# EUROPEAN PATENT SPECIFICATION

(11) **EP 3 349 550 B1**
(45) Date of publication and mention of the grant of the patent: **24.04.2024**
(21) Application number: 18151590.9
(22) Date of filing: 15.01.2018
(51) Int. Cl.: H05K 1/11, H05K 3/30, H05K 3/34, H01R 43/02

(54) **FIXING APPARATUS**
BEFESTIGUNGSVORRICHTUNG
APPAREIL DE FIXATION

(30) Priority: 13.01.2017 CN 201710024577
(43) Date of publication of application: 18.07.2018
(73) Proprietor: Tyco Electronics (Shanghai) Co., Ltd., Pilot Free Trade Zone Shanghai (CN); Measurement Specialities (Chengdu) Ltd., Chendu Sichuan 610213 (CN); TE Connectivity Solutions GmbH, 8200 Schaffhausen (CH)
(72) Inventor: DENG, Yingcong, Shanghai, Shanghai (CN); GONG, Lan, Shanghai, Shanghai (CN); YING, Qian, Shanghai, Shanghai (CN); ZHANG, Dandan, Shanghai, Shanghai (CN); HU, Lvhai, Shanghai, Shanghai (CN); LIU, Yun, Shanghai, Shanghai (CN); YE, Lin, Shanghai, Shanghai (CN); YAN, Yong, Shanghai, Shanghai (CN); LU, Roberto Francisco - Yi, Shanghai, Shanghai (CN); ZENG, Qinglong, Shanghai, Shanghai (CN)
(74) Representative: Grünecker Patent- und Rechtsanwälte PartG mbB

(56) References cited:
- JP-A- S 566 462
- JP-A- H11 104 820
- JP-A- S63 287 047
- US-A- 3 972 463
- US-A1- 2013 186 941
- US-A1- 2014 191 457

## Description

### CROSS-REFERENCE TO RELATED APPLICATION

This application claims the benefit of Chinese Patent Application No.CN201710024577.X filed on January 13, 2017 in the State Intellectual Property Office of China.

### BACKGROUND OF THE DISCLOSURE

### Field of the Disclosure

Embodiments of the disclosure relate to a fixing apparatus, and in particular to a fixing apparatus adapted to position and fix a circuit board and a wire.

### Description of the Related Art

In the field of electronics manufacturing technique, a circuit board and a wire are often required to be accurately positioned and fixed. For example, in the prior art, it is often to solder an elongated wire to a pad of the circuit board. In order to ensure soldering accuracy, In order to ensure the soldering accuracy, the wire and the circuit board are needed to be accurately positioned and fixed at a predetermined position in advance so that the wire is accurately aligned with the corresponding pad on the circuit board.

Currently, there is no such fixing device adapted to accurately position and fix the circuit board and the wire. Therefore, in the prior art, the circuit board and the wire are usually manually positioned and fixed, which undoubtedly reduces the soldering accuracy, thereby reducing the quality of a soldered product.

US 2013/186941 A1 shows a clamp assembly for inductive bonding. JP H11 104820 A discloses a positioning jig for soldering. In US 2014/191457 A1 a wire holder for managing and aligning wires to corresponding traces in a PCB is described. JP S63 287047 A relates to a method for fixing outer-lead hybrid integrated circuit. JP S63 287047 discloses a positioning method for metallic bars.

US 3,972,463 A discloses a microcircuit adhesion testing method and fixture for uniform placement and soldering of a preselected length of wire above a film pad on a microcircuit substrate with consistent substrate-to-wire spacing, comprising a holder for the substrate, finger spacers attached to the holder, and a member for pressing the wire against the spacers. The spacers are made of a material which is not wettable with solder of the type used to attach the wire to the film.

### SUMMARY OF THE DISCLOSURE

Embodiments of the disclosure have been made to overcome or alleviate at least one aspect of the above mentioned disadvantages.

The fixing apparatus of the present invention is defined in independent claim 1. Preferred embodiments of the claimed invention are defined in the dependent claims.

At least one embodiment of the disclosure provides a fixing apparatus adapted to accurately position and reliably hold a circuit board and a wire.

According to one aspect of the invention, there is provided a fixing apparatus, comprising: a first fixing device adapted to position and fix a circuit board having at least one pad; and a second fixing device adapted to position and fix at least one wire. The first fixing device is formed with a first positioning groove adapted to position the circuit board, and the second fixing device is formed with at least one second positioning groove adapted to position the at least one wire. The second positioning groove each is aligned with a corresponding pad on the circuit board so that the wire fixed in the second positioning groove is aligned with the corresponding pad on the circuit board.

According to one aspect of the invention, the first fixing device comprises: a first fixing base in which the first positioning groove is formed; and a first lock pivotally connected to a side of the first fixing base and adapted to be rotated between a locked position and the unlocked position. The first lock is adapted to hold and lock the circuit board in the first positioning groove when being in the locking position.

According to the invention, the first lock is formed with a first locking lip extending from one end thereof and adapted to lock an edge portion of the circuit board.

According to the invention, the first lock has a connection portion pivotally connected to the first fixing base between both ends thereof.

According to another aspect of the invention, the first fixing base is provided with a first spring adapted to push the other end of the first lock upwardly to hold the first lock in the locked position.

According to still another exemplary embodiment of the invention, when the first lock is applied with a downward pressing force at the other end thereof, the first lock overcomes a thrust of the first spring to be rotated from the locked position to the unlocked position, so that the first lock is separated from the circuit board.

According to another aspect of the invention, the first fixing base is formed with a receiving slot in which the first lock and the first spring are disposed. The connection portion of the first lock is pivotally connected to a sidewall of the receiving slot by a pivot shaft.

According to yet another exemplary embodiment of the disclosure, the second fixing device comprises: a second fixing base in which the second positioning groove is formed; a pressing cover pivotally connected to a side of the second fixing base and adapted to be rotated between an open state and an closed state; and a second lock pivotally connected to the other side of the second fixing base and adapted to be rotated between a locked position and an unlocked position. The pressing cover is adapted to press the wire in the second positioning groove when being in the closed state, and the second lock is adapted to lock the pressing cover in the closed state when being in the locked position.

According to still another exemplary embodiment of the disclosure, the second lock is formed with a second locking lip extending from one end thereof toward the second positioning groove and adapted to lock an edge portion of the pressing cover.

According to further another exemplary embodiment of the disclosure, the second lock is pivotally connected to the second fixing base at the other end thereof.

According to yet another exemplary embodiment of the disclosure, the second fixing base is provided with a second spring, one end of which is pressed against one end of the second lock to hold the second lock in the locked position.

According to still another exemplary embodiment of the disclosure, when the second lock is applied with a driving force against a thrust of the second spring at one end thereof, the second lock overcomes the thrust of the spring to be rotated from the locked position to the unlocked position so that the second lock is disengaged from the pressing cover.

According to further another exemplary embodiment of the disclosure, the pressing cover is pivotally connected to the second fixing base at one end thereof by a first pivot shaft. The second lock is pivotally connected to the second fixing base at the other end thereof by a second pivot shaft.

According to yet another exemplary embodiment of the disclosure, the second fixing base is formed with a pressing tongue horizontally forwardly extending, and the second positioning groove is formed on surfaces of the pressing tongue and the second fixing base. The pressing tongue is adapted to press an end portion of the wire fixed in the second positioning groove against a corresponding pad on the circuit board.

According to still another exemplary embodiment of the disclosure, the fixing apparatus further comprises a mounting base onto which the first fixing device and the second fixing device are mounted.

According to further another exemplary embodiment of the disclosure, the second fixing base is formed with a semicircular positioning recess at either end thereof, respectively. The mounting base is formed with two support platforms, each of which is formed with a circular positioning post. The second fixing base is supported on the two support platforms at both ends thereof, respectively, and the positioning posts are fitted in the positioning recesses of the second fixing base, respectively.

According to yet another exemplary embodiment of the disclosure, after the second fixing device is mounted onto the mounting base, the pressing cover is located below the second fixing base and faces a surface of the mounting base.

According to still another exemplary embodiment of the disclosure, after the second fixing device is mounted onto the mounting base, the pressing cover is not in contact the surface of the mounting base, so that the second fixing device is suspended and supported on the mounting base by the two support platforms.

According to further another exemplary embodiment of the disclosure, the fixing apparatus further comprises: a plurality of first fixing devices arranged in a row to allow a plurality of circuit boards to be simultaneously positioned and fixed; and a plurality of second fixing devices arranged in a row to allow a plurality of rows of wires to be simultaneously positioned and fixed.

In the above-described various embodiments of the disclosure, the circuit board and the wire may be accurately positioned and reliably held in the corresponding positioning grooves, thereby improving the positioning accuracy and reliability of the wire and the circuit board, which facilitates to improving the accuracy of soldering the wire to the circuit board.

Other objects and advantages of the disclosure will become apparent from the following description of the disclosure when taken in conjunction with the accompanying drawings, and may give a comprehensive understanding of the disclosure.

### BRIEF DESCRIPTION OF THE DRAWINGS

The above and other features of the disclosure will become more apparent by describing in detail exemplary embodiments thereof with reference to the accompanying drawings, in which:
FIG 1 shows a schematic perspective view of a fixing apparatus according to an example embodiment of the disclosure;
FIG 2 shows a schematic perspective view of a first fixing device and a second fixing device of the fixing apparatus shown in FIG 1;
FIG 3 shows a schematic perspective view of the second fixing device shown in FIG 2 with a pressing cover being in an open state;
FIG 4 shows a cross-sectional view of the second fixing device shown in FIG 3 with the pressing being in the open state;
FIG 5 shows a schematic perspective view of the first fixing device shown in FIG 2 with a first lock being in a locking position; and
FIG 6 shows a cross-sectional view of the first fixing device shown in FIG 2 with the first lock being in an unlocked position.

### DETAILED DESCRIPTION OF PREFERRED EMBODIMENTS OF THE DISCLOSURE

The technical solution of the disclosure will be described hereinafter in further detail with reference to the following embodiments, taken in conjunction with the accompanying drawings. In the specification, the same or similar reference numerals indicate the same or similar parts. The description of the embodiments of the disclosure hereinafter with reference to the accompanying drawings is intended to explain the general inventive concept of the disclosure and should not be construed as a limitation on the disclosure.

In addition, in the following detailed description, for the sake of explanation, numerous specific details are set forth in order to provide a thorough understanding of the disclosed embodiments. It will be apparent, however, that one or more embodiments may also be practiced without these specific details. In other instances, well-known structures and devices are illustrated schematically in order to simplify the drawing.

According to a general technical concept of the disclosure, there is provided a fixing apparatus, comprising: a first fixing device adapted to position and fix a circuit board having at least one pad; and a second fixing device adapted to position and fix at least one wire. The first fixing device is formed with a first positioning groove adapted to position the circuit board, and the second fixing device is formed with at least one second positioning groove adapted to position the at least one wire. Each second positioning groove is aligned with a corresponding pad on the circuit board so that the wire fixed in the second positioning groove is aligned with the corresponding pad on the circuit board.

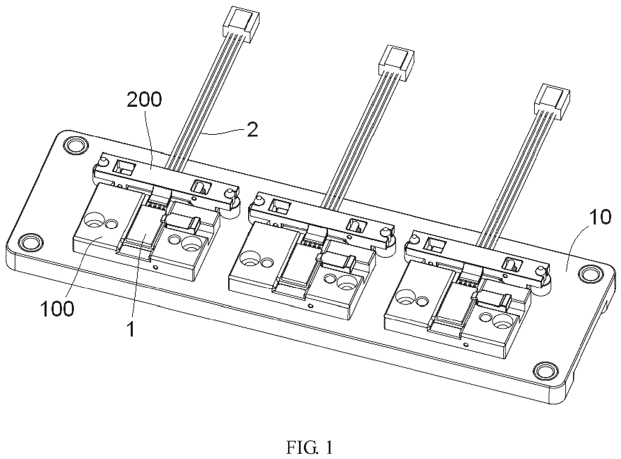

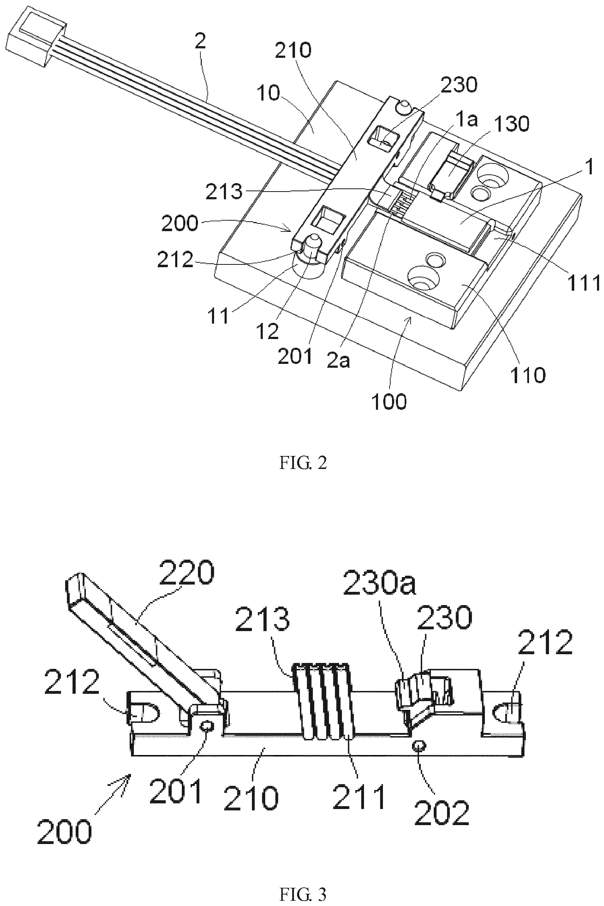

FIG 1 shows a schematic perspective view of a fixing apparatus according to an example embodiment of the disclosure. FIG 2 shows a perspective view of a first fixing device 100 and a second fixing device 200 of the fixing apparatus shown in FIG 1.

As shown in FIGS. 1 and 2, in the illustrated embodiment, the fixing apparatus mainly comprises a first fixing device 100 adapted to position and fix a circuit board 1, and a second fixing device 200 adapted to position and fix at least one wire 2.

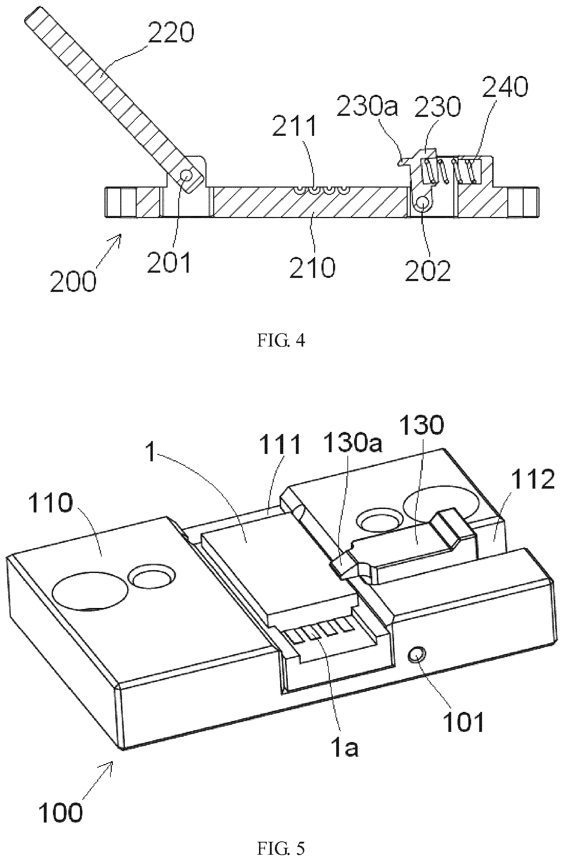

FIG 3 shows a schematic perspective view of the second fixing device 200 shown in FIG 2 with a pressing cover 220 being in an open state; FIG 5 shows a schematic perspective view of the first fixing device 100 shown in FIG 2 with a first locking device 130 being in a lock position.

As shown in FIG 5, in the illustrated embodiment, the first fixing device 100 is formed with a first positioning groove 111 adapted to position the circuit board 1 having at least one pad 1a. As shown in FIG 3, in the illustrated embodiment, the second fixing device 200 is formed with at least one second positioning groove 211 adapted to position the at least one wire 2 to be electrically connected to the at least one pads of the circuit board 1, respectively.

As shown in FIGS. 2, 3 and 5, in the illustrated embodiment, each second positioning groove 211 is aligned with a corresponding pad 1a on the circuit board 1 so that the wire 2 fixed in the second positioning groove 211 is aligned with the corresponding pad 1a on the circuit board 1.

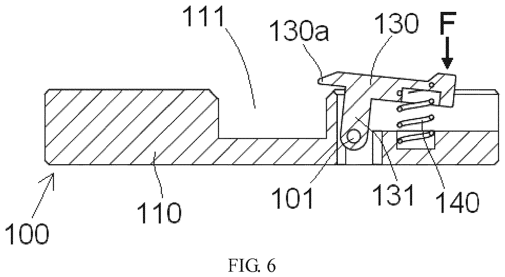

FIG 6 shows a cross-sectional view of the first fixing device 100 shown in FIG 2 with a first lock 130 being in an unlocked position.

As shown in FIGS. 5 and 6, in the illustrated embodiment, the first fixing device 100 mainly comprises a first fixing base 110 and the first lock 130. The first positioning groove 111 is formed in the first fixing base 110 and extending in an axial direction of the wire 2. The first lock 130 is pivotally connected to a side of the first fixing base 110 and adapted to be rotated between a locked position and the unlocked position.

As shown in FIG 5, in the illustrated embodiment, the first lock 130 is adapted to hold and lock the circuit board 1 in the first positioning groove 111 when being in the locking position.

As shown in FIGS. 5 and 6, in the illustrated embodiment, the first lock 130 is formed with a first locking lip 130a extending from one end thereof (left end in Fig. 6) toward the first positioning groove 111 and adapted to be locked onto an edge portion of the circuit board 1. In this way, the circuit board 1 is held in the first positioning groove 111.

As shown in FIGS. 5 and 6, in the illustrated embodiment, the first lock 130 has a connection portion 131 pivotally connected to the first fixing base 110 between both ends thereof.

As shown in FIG 5 and FIG 6, in the illustrated embodiment, the first fixing base 110 is provided with a first spring 140 extending in a thickness direction of the second fixing base 210 and adapted to push the other of the first lock 130 upwardly to hold the first lock 130 in the locked position.

As shown in FIGS. 5 and 6, in the illustrated embodiment, when the first lock 130 is applied with a downward pressing force F at the other end thereof (right end in Fig. 6) against the first spring 140, the first lock 130 may overcome a thrust of the first spring 140 to be rotated from the locked position to the unlocked position, so that the first lock 130 is disengaged from the circuit board 1.

As shown in FIGS. 5 and 6, in the illustrated embodiment, when the downward pressing force F applied to the other end of the first lock 130 is released, the first lock 130 may be automatically rotated from the unlock position to the locked position under the thrust of the first spring 140.

As shown in FIGS. 5 and 6, in the illustrated embodiment, the first fixing base 110 is formed with a receiving slot 112 extending in a direction perpendicular to the axial direction of the wire 2, in which the first lock 130 and the first spring 140 are disposed. The connection portion 131 of the first lock 130 is pivotally connected to a sidewall of the receiving slot 112 by a pivot shaft 101.

FIG 4 shows a cross-sectional view of the second fixing device 200 shown in FIG 3 with the pressing cover 220 being in the open state.

As shown in FIGS. 3 and 4, in the illustrated embodiment, the second fixing device 200 mainly comprises a second fixing base 210, the pressing cover 220 and a second lock 230. The second positioning groove 211 is formed in the second fixing base 210. The pressing cover 220 is pivotally connected to a side of the second fixing base 210 and adapted to be rotated between the open state and the closed state. The second lock 230 is pivotally connected to the other side of the second fixing base 210 opposite to the one side and adapted to be rotated between a locked position and an unlocked position.

As shown in FIGS 2 and 3, in the illustrated embodiment, the pressing cover 220 is adapted to press and hold the wire 2 in the second positioning groove 211 when being in the closed state. The second lock 230 is adapted to lock the pressing cover 220 in the closed state when being in the locked position.

As shown in FIGS. 3 and 4, in the illustrated embodiment, the second lock 230 is formed with a second locking lip 230a which extends from one end thereof (upper end in Fig. 4) toward the second positioning groove 211 and is adapted to be locked onto an edge portion of the pressing cover 220.

As shown in FIGS. 3 and 4, in the illustrated embodiment, the second lock 230 is pivotally connected to the second fixing base 210 at the other end thereof opposite to the one side (lower end in Fig. 4).

As shown in FIGS. 3 and 4, in the illustrated embodiment, the second fixing base 210 is provided with a second spring 240 extending in the direction perpendicular to the axial direction of the wire 2, one end of which is pressed against one end of the second lock 230 to hold the second lock 230 in the locked position.

As shown in FIGS. 3 and 4, in the illustrated embodiment, when the second lock 230 is applied with a driving force against a thrust of the second spring 240 at the one end thereof, the second lock 230 may overcome the thrust of the spring 240 to be rotated from the locked position to the unlocked position so that the second lock 230 is disengaged from the pressing cover 220.

As shown in FIGS. 3 and 4, in the illustrated embodiment, when the driving force applied to one end of the second lock 230 is released, the second lock 230 may be automatically rotated from the unlocked position to the locked position under the thrust of the second spring 240.

As shown in FIGS. 3 and 4, in the illustrated embodiment, the pressing cover 220 is pivotally connected to the second fixing base 210 at one end thereof by a first pivot shaft 201. Further, the second lock 230 is pivotally connected to the second fixing base 210 at the other end thereof (lower end in Fig. 4) by a second pivot shaft 202.

As shown in FIGS. 2 and FIG 3, in the illustrated embodiment, the second fixing base 210 is formed with a pressing tongue 213 horizontally forwardly extending toward the first fixing base 110 in the axial direction of the wire 2, and the second positioning groove 211 is formed on surfaces of the pressing tongue 213 and the second fixing base 210. As shown in FIG 2, the pressing tongue 213 is adapted to press an end portion 2a of the wire 2 fixed in the second positioning groove 211 against a corresponding pad 1a on the circuit board 1.

As shown in FIGS. 1 and 2, in the illustrated embodiment, the fixing apparatus further comprises a mounting base 10 onto which the first fixing device 100 and the second fixing device 200 are mounted.

As shown in FIGS. 2 and 3, in the illustrated embodiment, the second fixing base 210 is formed with a semicircular positioning recess 212 at either end thereof, respectively. The mounting base 10 is formed with two support platforms 11, each of which is formed with a circular positioning post 12. The second fixing base 210 are supported on the two support platforms 11 at both ends thereof, respectively, and the positioning posts 12 are fitted in the positioning recesses 212 of the second fixing base 210, respectively.

As shown in FIGS. 1-3, in the illustrated embodiment, before connecting the wires 2 to the circuit board 1, the second fixing device 200 is firstly disassembled from the mounting base 10; the wires are clamped between the pressing cover 220 and the second fixing base 210; and the second fixing device 200 is then mounted onto the mounting base 10 by the positioning posts 12 and the positioning recesses 212. After the second fixing device 200 is mounted onto the mounting base 10, the pressing cover 220 is located below the second fixing base 210 and faces a surface of the mounting base 10.

As shown in FIGS. 2 and 3, in the illustrated embodiment, after the second fixing device 200 is mounted onto the mounting base 10, the pressing cover 220 is not in contact the surface of the mounting base 10, so that the second fixing device 200 is suspended and supported on the mounting base 10 by the two support platforms 11.

As shown in FIG 1, in the illustrated embodiment, the fixing apparatus may comprise a plurality of first fixing devices 100 arranged in a row to allow a plurality of circuit boards 1 to be simultaneously positioned and fixed. The fixing apparatus may comprise a plurality of second fixing devices 200 arranged in a row to allow a plurality of rows of wires 2 to be simultaneously positioned and fixed. In this way, it is possible to simultaneously solder the plurality of rows of wires 2 to the plurality of circuit boards 1 respectively, thereby improving the soldering efficiency.

It should be appreciated by those skilled in this art that the above embodiments are intended to be illustrative, and many modifications may be made to the above embodiments by those skilled in this art, and various structures described in various embodiments may be freely combined with each other without conflicting in configuration or principle.

Although the disclosure have been described hereinbefore in detail with reference to the attached drawings, it should be appreciated that the disclosed embodiments in the attached drawings are intended to illustrate the preferred embodiments of the disclosure by way of example, and should not be construed as limitation to the disclosure.

Although several exemplary embodiments have been shown and described, it would be appreciated by those skilled in the art that various changes or modifications may be made to these embodiments without departing from the principles of the disclosure, the scope of which is defined by the claims.

It should be noted that, the word "comprise" doesn't exclude other elements or steps, and the word "a" or "an" doesn't exclude more than one. In addition, any reference numerals in the claims should not be interpreted as the limitation to the scope of the disclosure.

## Claims

1. A fixing apparatus, comprising:
a first fixing device (100) adapted to position and fix a circuit board (1) having at least one pad (1a); and
a second fixing device (200) adapted to position and fix at least one wire (2),
**wherein**
the first fixing device (100) comprises a first fixing base (110), in which a first positioning groove (111) is formed, that is adapted to position the circuit board (1), and the second fixing device (200) is formed with at least one second positioning groove (211) adapted to position the at least one wire (2); and
each second positioning groove (211) is aligned with a corresponding pad (1a) on the circuit board (1) so that the wire (2) fixed in the second positioning groove (211) is aligned with the corresponding pad (1a) on the circuit board (1), **characterized in that**
the first fixing device (100) further comprises:
a first lock (130) pivotally connected to a side of the first fixing base (110) and adapted to be rotated between a locked position and the unlocked position,
wherein the first lock (130) is formed with a first locking lip (130a)
extending from one end thereof and adapted to lock an edge portion of the circuit board (1);
wherein the first lock (130) has a connection portion (131) pivotally connected to the first fixing base (110) between both ends thereof;
wherein the first lock (130) is adapted to hold and lock the circuit board (1) in the first positioning groove (111) when being in the locking position, wherein the first fixing base (110) is provided with a first spring (140) adapted to push the other end of the first lock (130) upwardly to hold the first lock (130) in the locked position; and wherein
the first fixing base (110) is formed with a receiving slot (112) in which the first lock (130) and the first spring (140) are disposed; and
the connection portion (131) of the first lock (130) is pivotally connected to a sidewall of the receiving slot (112) by a pivot shaft (101).

2. The fixing apparatus according to claim 1, **characterized in that**
when the first lock (130) is applied with a downward pressing force at the other end thereof, the first lock (130) overcomes a thrust of the first spring (140) to be rotated from the locked position to the unlocked position, so that the first lock (130) is separated from the circuit board (1).

3. The fixing apparatus according to any one of claims 1 to 2, **characterized in that** the second fixing device (200) comprises:
a second fixing base (210) in which the second positioning groove (211) is formed;
a pressing cover (220) pivotally connected to a side of the second fixing base (210) and adapted to be rotated between an open state and an closed state; and
a second lock (230) pivotally connected to the other side of the second fixing base (210) and adapted to be rotated between a locked position and an unlocked position,
wherein the pressing cover (220) is adapted to press the wire (2) in the second positioning groove (211) when being in the closed state; and the second lock (230) is adapted to lock the pressing cover (220) in the closed state when being in the locked position.

4. The fixing apparatus according to claim 3, **characterized in that**
the second lock (230) is formed with a second locking lip (230a) extending from one end thereof toward the second positioning groove and adapted to locked an edge portion of the pressing cover (220); and
the second lock (230) is pivotally connected to the second fixing base (210) at the other end thereof.

5. The fixing apparatus according to claim 3 or 4, **characterized in that**
the second fixing base (210) is provided with a second spring (240), one end of which is pressed against one end of the second lock (230) to hold the second lock (230) in the locked position; and
when the second lock (230) is applied with a driving force against a thrust of the second spring (240) at one end thereof, the second lock (230) overcomes the thrust of the spring (240) to be rotated from the locked position to the unlocked position so that the second lock (230) is disengaged from the pressing cover (220).

6. The fixing apparatus according to any one of claims 3 to 5, **characterized in that**
the pressing cover (220) is pivotally connected to the second fixing base (210) at one end thereof by a first pivot shaft (201); and
the second lock (230) is pivotally connected to the second fixing base (210) at the other end thereof by a second pivot shaft (202).

7. The fixing apparatus according to any one of claims 3 to 6, **characterized in that**
the second fixing base (210) is formed with a pressing tongue (213) horizontally forwardly extending, and the second positioning groove (211) is formed on surfaces of the pressing tongue (213) and the second fixing base (210); and
the pressing tongue (213) is adapted to press an end portion (2a) of the wire (2) fixed in the second positioning groove (211) against a corresponding pad (1a) on the circuit board (1).

8. The fixing apparatus according to any one of claims 3 to 7, **characterized in that** further comprising a mounting base (10) onto which the first fixing device (100) and the second fixing device (200) are mounted;
wherein the second fixing base (210) is formed with a semicircular positioning recess (212) at either end thereof, respectively; and the mounting base (10) is formed with two support platforms (11), each of which is formed with a circular positioning post (12); and
wherein the second fixing base (210) are supported on the two support platforms (11) at both ends thereof, respectively, and the positioning posts (12) are fitted in the positioning recesses (212) of the second fixing base (210), respectively.

9. The fixing apparatus according to claim 8, **characterized in that** after the second fixing device (200) is mounted onto the mounting base (10), the pressing cover (220) is located below the second fixing base (210) and faces a surface of the mounting base (10).

10. The fixing apparatus according to claim 8 or 9, **characterized in that** after the second fixing device (200) is mounted onto the mounting base (10), the pressing cover (220) is not in contact the surface of the mounting base (10), so that the second fixing device (200) is suspended and supported on the mounting base (10) by the two support platforms (11).

11. The fixing apparatus according to any one of claims 1 to 10, **characterized in that** further comprising:
a plurality of first fixing devices (100) arranged in a row to allow a plurality of circuit boards (1) to be simultaneously positioned and fixed; and
a plurality of second fixing devices (200) arranged in a row to allow a plurality of rows of wires (2) to be simultaneously positioned and fixed.

## Patentansprüche

1. Eine Befestigungsvorrichtung, umfassend:
eine erste Befestigungsvorrichtung (100), die geeignet ist, eine Leiterplatte (1) mit mindestens einer Kontaktfläche (1a) zu positionieren und zu befestigen; und
eine zweite Befestigungsvorrichtung (200), die geeignet ist, mindestens einen Draht (2) zu positionieren und zu befestigen,
**wobei**
die erste Befestigungsvorrichtung (100) eine erste Befestigungsbasis (110) umfasst, in der eine erste Positionierungsrille (111) ausgebildet ist, die angepasst ist, um die Leiterplatte (1) zu positionieren, und die zweite Befestigungsvorrichtung (200) mit mindestens einer zweiten Positionierungsrille (211) ausgebildet ist, die angepasst ist, um den mindestens einen Draht (2) zu positionieren; und
jede zweite Positionierungsrille (211) mit einem entsprechenden Pad (1a) auf der Leiterplatte (1) ausgerichtet ist, so dass der in der zweiten Positionierungsrille (211) befestigte Draht (2) mit dem entsprechenden Pad (1a) auf der Leiterplatte (1) ausgerichtet ist, **dadurch gekennzeichnet, dass**
die erste Befestigungsvorrichtung (100) ferner umfasst:
eine erste Verriegelung (130), die schwenkbar mit einer Seite der ersten Befestigungsbasis (110) verbunden ist und zwischen einer verriegelten Position und der entriegelten Position gedreht werden kann,
wobei die erste Verriegelung (130) mit einer ersten Verriegelungslippe (130a) ausgebildet ist, die sich von einem Ende davon erstreckt und angepasst ist, einen Kantenabschnitt der Leiterplatte (1) zu verriegeln;
wobei die erste Verriegelung (130) einen Verbindungsabschnitt (131) aufweist, der schwenkbar mit der ersten Befestigungsbasis (110) zwischen deren beiden Enden verbunden ist;
wobei die erste Verriegelung (130) geeignet ist, die Leiterplatte (1) in der ersten Positionierungsnut (111) zu halten und zu verriegeln, wenn sie sich in der Verriegelungsposition befindet, wobei die erste Befestigungsbasis (110) mit einer ersten Feder (140) versehen ist, die geeignet ist, das andere Ende der ersten Verriegelung (130) nach oben zu drücken, um die erste Verriegelung (130) in der verriegelten Position zu halten; und wobei
die erste Befestigungsbasis (110) mit einem Aufnahmeschlitz (112) ausgebildet ist, in dem das erste Schloss (130) und die erste Feder (140) angeordnet sind; und
der Verbindungsabschnitt (131) der ersten Verriegelung (130) schwenkbar mit einer Seitenwand des Aufnahmeschlitzes (112) durch eine Schwenkwelle (101) verbunden ist.

2. Die Befestigungsvorrichtung nach Anspruch 1, **dadurch gekennzeichnet, dass**
wenn die erste Verriegelung (130) mit einer nach unten gerichteten Druckkraft an ihrem anderen Ende beaufschlagt wird, die erste Verriegelung (130) einen Druck der ersten Feder (140) überwindet, um von der verriegelten Position in die entriegelte Position gedreht zu werden, so dass die erste Verriegelung (130) von der Leiterplatte (1) getrennt wird.

3. Befestigungsvorrichtung nach einem der Ansprüche 1 bis 2, **dadurch gekennzeichnet, dass** die zweite Befestigungsvorrichtung (200) umfasst:
einen zweite Befestigungsbasis (210), in dem die zweite Positionierungsrille (211) ausgebildet ist;
einen Pressdeckel (220), der schwenkbar mit einer Seite der zweiten Befestigungsbasis (210) verbunden ist und zwischen einem offenen Zustand und einem geschlossenen Zustand gedreht werden kann; und
eine zweite Verriegelung (230), die schwenkbar mit der anderen Seite der zweiten Befestigungsbasis (210) verbunden ist und zwischen einer verriegelten Position und einer entriegelten Position gedreht werden kann,
wobei der Pressdeckel (220) so angepasst ist, dass sie den Draht (2) in die zweite Positionierungsrille (211) drückt, wenn sie sich im geschlossenen Zustand befindet; und die zweite Verriegelung (230) so angepasst ist, dass sie den Pressdeckel (220) im geschlossenen Zustand verriegelt, wenn sie sich in der verriegelten Position befindet.

4. Befestigungsvorrichtung nach Anspruch 3, **dadurch gekennzeichnet, dass**
die zweite Verriegelung (230) mit einer zweiten Verriegelungslippe (230a) ausgebildet ist, die sich von einem Ende derselben in Richtung der zweiten Positionierungsnut erstreckt und dazu geeignet ist, einen Kantenabschnitt des Pressdeckels (220) zu verriegeln; und
die zweite Verriegelung (230) schwenkbar mit der zweiten Befestigungsbasis (210) an deren anderem Ende verbunden ist.

5. Befestigungsvorrichtung nach Anspruch 3 oder 4, **dadurch gekennzeichnet, dass**
die zweite Befestigungsbasis (210) mit einer zweiten Feder (240) versehen ist, deren eines Ende gegen ein Ende des zweiten Schlosses (230) gedrückt wird, um das zweite Schloss (230) in der verriegelten Position zu halten; und
wenn die zweite Verriegelung (230) mit einer Antriebskraft gegen einen Druck der zweiten Feder (240) an einem Ende davon beaufschlagt wird, die zweite Verriegelung (230) den Druck der Feder (240) überwindet, um von der verriegelten Position in die entriegelte Position gedreht zu werden, so dass die zweite Verriegelung (230) von dem Pressdeckel (220) gelöst wird.

6. Befestigungsvorrichtung nach einem der Ansprüche 3 bis 5, **dadurch gekennzeichnet, dass**
der Pressdeckel (220) mit der zweiten Befestigungsbasis (210) an einem Ende desselben durch eine erste Drehachse (201) schwenkbar verbunden ist; und
die zweite Verriegelung (230) mit der zweiten Befestigungsbasis (210) an deren anderem Ende durch eine zweite Drehachse (202) drehbar verbunden ist.

7. Befestigungsvorrichtung nach einem der Ansprüche 3 bis 6, **dadurch gekennzeichnet, dass**
die zweite Befestigungsbasis (210) mit einer sich horizontal nach vorne erstreckenden Druckzunge (213) ausgebildet ist und die zweite Positionierungsnut (211) an Oberflächen der Druckzunge (213) und der zweiten Befestigungsbasis (210) ausgebildet ist; und
die Druckzunge (213) dazu geeignet ist, einen Endabschnitt (2a) des in der zweiten Positionierungsnut (211) befestigten Drahtes (2) gegen ein entsprechendes Pad (1a) auf der Leiterplatte (1) zu drücken.

8. Befestigungsvorrichtung nach einem der Ansprüche 3 bis 7, **dadurch gekennzeichnet, dass** sie ferner eine Montagebasis (10) umfasst, auf der die erste Befestigungsvorrichtung (100) und die zweite Befestigungsvorrichtung (200) montiert sind;
wobei die zweite Befestigungsbasis (210) mit einer halbkreisförmigen Positionierungsaussparung (212) an jedem ihrer Enden ausgebildet ist; und die Befestigungsbasis (10) mit zwei Stützplattformen (11) ausgebildet ist, von denen jede mit einem kreisförmigen Positionierungspfosten (12) ausgebildet ist; und
wobei die zweite Befestigungsbasis (210) auf den beiden Stützplattformen (11) an ihren beiden Enden abgestützt ist und die Positionierungspfosten (12) jeweils in die Positionierungsaussparungen (212) der zweiten Befestigungsbasis (210) eingepasst sind.

9. Befestigungsvorrichtung nach Anspruch 8, **dadurch gekennzeichnet, dass** nach der Montage der zweiten Fixiervorrichtung (200) an der Befestigungsbasis (10), der Pressdeckel (220) unterhalb der zweiten Befestigungsbasis (210) angeordnet ist und einer Oberfläche der Befestigungsbasis (10) zugewandt ist.

10. Befestigungsvorrichtung nach Anspruch 8 oder 9, **dadurch gekennzeichnet, dass** nach der Montage der zweiten Fixiervorrichtung (200) an der Befestigungsbasis (10), der Pressdeckel (220) nicht in Kontakt mit der Oberfläche der Befestigungsbasis (10) ist, so dass die zweite Fixiervorrichtung (200) auf der Befestigungsbasis (10) aufgehängt ist und von den beiden Stützplattformen (11) getragen wird.

11. Befestigungsvorrichtung nach einem der Ansprüche 1 bis 10, **dadurch gekennzeichnet, dass** sie ferner umfasst:
eine Vielzahl von ersten Befestigungsvorrichtungen (100), die in einer Reihe angeordnet sind, damit eine Vielzahl von Leiterplatten (1) gleichzeitig positioniert und befestigt werden können; und
eine Vielzahl von zweiten Befestigungsvorrichtungen (200), die in einer Reihe angeordnet sind, damit eine Vielzahl von Reihen von Drähten (2) gleichzeitig positioniert und befestigt werden können.

## Revendications

1. Appareil de fixation, comprenant :
un premier dispositif de fixation (100) adapté pour positionner et fixer une carte de circuit imprimé (1) ayant au moins un plot (1a) ; et
un deuxième dispositif de fixation (200) adapté pour positionner et fixer au moins un fil (2),
**dans lequel**
le premier dispositif de fixation (100) comprend une première base de fixation (110), dans laquelle une première rainure de positionnement (111) est formée, qui est adaptée pour positionner la carte de circuit imprimé (1), et le deuxième dispositif de fixation (200) est formé d'au moins une deuxième rainure de positionnement (211) adaptée pour positionner l'au moins un fil (2) ; et
chaque deuxième rainure de positionnement (211) est alignée avec un plot correspondant (1a) sur la carte de circuit imprimé (1) de sorte que le fil (2) fixé dans la deuxième rainure de positionnement (211) soit aligné avec le plot correspondant (1a) sur la carte de circuit imprimé (1), **caractérisé en ce que**
le premier dispositif de fixation (100) comprend en outre :
un premier verrou (130) connecté en pivotement à un côté de la première base de fixation (110) et adapté pour être tourné entre une position verrouillée et la position déverrouillée,
dans lequel le premier verrou (130) est formé d'une première lèvre de verrouillage (130a) s'étendant depuis une extrémité de celui-ci et adaptée pour verrouiller une partie de bord de la carte de circuit imprimé (1) ;
dans lequel le premier verrou (130) a une partie de connexion (131) connectée en pivotement à la première base de fixation (110) entre ses deux extrémités ;
dans lequel le premier verrou (130) est adapté pour maintenir et verrouiller la carte de circuit imprimé (1) dans la première rainure de positionnement (111) lorsqu'il est dans la position de verrouillage, dans lequel la première base de fixation (110) est pourvue d'un premier ressort (140) adapté pour pousser l'autre extrémité du premier verrou (130) vers le haut pour maintenir le premier verrou (130) dans la position verrouillée ; et dans lequel
la première base de fixation (110) est formée d'une fente de réception (112) dans laquelle sont disposés le premier verrou (130) et le premier ressort (140) ; et
la partie de connexion (131) du premier verrou (130) est connectée en pivotement à une paroi latérale de la fente de réception (112) par un arbre pivotant (101).

2. Appareil de fixation selon la revendication 1, **caractérisé en ce que**
lorsque le premier verrou (130) est soumis à une force de pression vers le bas au niveau de l'autre extrémité de celui-ci, le premier verrou (130) surmonte une poussée du premier ressort (140) pour tourner de la position verrouillée à la position déverrouillée, de sorte que le premier verrou (130) soit séparé de la carte de circuit imprimé (1).

3. Appareil de fixation selon l'une quelconque des revendications 1 et 2, **caractérisé en ce que**
le deuxième dispositif de fixation (200) comprend :
une deuxième base de fixation (210) dans laquelle est formée la deuxième rainure de positionnement (211) ;
un couvercle de pression (220) connecté en pivotement à un côté de la deuxième base de fixation (210) et adapté pour être tourné entre un état ouvert et un état fermé ; et
un deuxième verrou (230) connecté en pivotement à l'autre côté de la deuxième base de fixation (210) et adapté pour être tourné entre une position verrouillée et une position déverrouillée,
dans lequel le couvercle de pression (220) est adapté pour presser le fil (2) dans la deuxième rainure de positionnement (211) lorsqu'il est dans l'état fermé ; et le deuxième verrou (230) est adapté pour verrouiller le couvercle de pression (220) dans l'état fermé lorsqu'il est dans la position verrouillée.

4. Appareil de fixation selon la revendication 3, **caractérisé en ce que**
le deuxième verrou (230) est formé d'une deuxième lèvre de verrouillage (230a) s'étendant depuis une extrémité de celui-ci vers la deuxième rainure de positionnement et adaptée pour verrouiller une partie de bord du couvercle de pression (220) ; et
le deuxième verrou (230) est connecté en pivotement à la deuxième base de fixation (210) au niveau de l'autre extrémité de celui-ci.

5. Appareil de fixation selon la revendication 3 ou 4, **caractérisé en ce que**
la deuxième base de fixation (210) est pourvue d'un deuxième ressort (240) dont une extrémité est pressée contre une extrémité du deuxième verrou (230) pour maintenir le deuxième verrou (230) dans la position verrouillée ; et
lorsque le deuxième verrou (230) est soumis à une force d'entraînement contre une poussée du deuxième ressort (240) au niveau d'une extrémité de celui-ci, le deuxième verrou (230) surmonte la poussée du ressort (240) pour être tourné de la position verrouillée à la position déverrouillée de sorte que le deuxième verrou (230) soit désengagé du couvercle de pression (220).

6. Appareil de fixation selon l'une quelconque des revendications 3 à 5, **caractérisé en ce que**
le couvercle de pression (220) est connecté en pivotement à la deuxième base de fixation (210) au niveau d'une extrémité de celui-ci par un premier arbre pivotant (201) ; et
le deuxième verrou (230) est connecté en pivotement à la deuxième base de fixation (210) au niveau de l'autre extrémité de celui-ci par un deuxième arbre pivotant (202).

7. Appareil de fixation selon l'une quelconque des revendications 3 à 6, **caractérisé en ce que**
la deuxième base de fixation (210) est formée d'une languette de pression (213) s'étendant horizontalement vers l'avant, et la deuxième rainure de positionnement (211) est formée sur des surfaces de la languette de pression (213) et de la deuxième base de fixation (210) ; et
la languette de pression (213) est adaptée pour presser une partie d'extrémité (2a) du fil (2) fixée dans la deuxième rainure de positionnement (211) contre un plot correspondant (1a) sur la carte de circuit imprimé (1).

8. Appareil de fixation selon l'une quelconque des revendications 3 à 7, **caractérisé en ce qu'**il comprend en outre une base de montage (10) sur laquelle sont montés le premier dispositif de fixation (100) et le deuxième dispositif de fixation (200) ;
dans lequel la deuxième base de fixation (210) est formée d'un évidement de positionnement semi-circulaire (212) au niveau de chaque extrémité de celle-ci, respectivement ; et la base de montage (10) est formée de deux plates-formes de support (11), dont chacune est formée d'un montant de positionnement circulaire (12) ; et
dans lequel la deuxième base de fixation (210) est supportée sur les deux plates-formes de support (11) au niveau des deux extrémités de celle-ci, respectivement, et les montants de positionnement (12) sont ajustés dans les évidements de positionnement (212) de la deuxième base de fixation (210), respectivement.

9. Appareil de fixation selon la revendication 8, **caractérisé en ce que,** après le montage du deuxième dispositif de fixation (200) sur la base de montage (10), le couvercle de pression (220) est situé en dessous de la deuxième base de fixation (210) et fait face à une surface de la base de montage (10).

10. Appareil de fixation selon la revendication 8 ou 9, **caractérisé en ce que,** après le montage du deuxième dispositif de fixation (200) sur la base de montage (10), le couvercle de pression (220) n'est pas en contact avec la surface de la base de montage (10), de sorte que le deuxième dispositif de fixation (200) soit suspendu et supporté sur la base de montage (10) par les deux plates-formes de support (11).

11. Appareil de fixation selon l'une quelconque des revendications 1 à 10, **caractérisé en ce qu'il** comprend en outre :
une pluralité de premiers dispositifs de fixation (100) agencés en rangée pour permettre à une pluralité de cartes de circuit imprimé (1) d'être positionnées et fixées simultanément ; et
une pluralité de deuxièmes dispositifs de fixation (200) agencés en rangée pour permettre à une pluralité de rangées de fils (2) d'être positionnées et fixées simultanément.
